# EUROPEAN PATENT APPLICATION

(11) **EP 4 607 543 A1**
(43) Date of publication of application: **27.08.2025**
(21) Application number: 23879623.9
(22) Date of filing: 05.10.2023
(51) Int. Cl.: H01F 1/11, C04B 35/26, H01F 1/117, H01F 1/34, H05K 9/00

(54) **FERRITE PARTICLE POWDER FOR ELECTROMAGNETIC WAVE ABSORPTION, METHOD FOR MANUFACTURING SAME, RESIN COMPOSITION USING SAME, AND ELECTROMAGNETIC WAVE ABSORBING MATERIAL**

(30) Priority: 21.10.2022 JP 2022169408
(71) Applicant: Toda Kogyo Corp., Hiroshima 732-0828 (JP)
(72) Inventor: KAMIKAWA, Shuhei, Otake-shi, Hiroshima 739-0652 (JP); NISHIO, Yasushi, Otake-shi, Hiroshima 739-0652 (JP)
(74) Representative: Dennemeyer & Associates S.A.
(86) International application number: PCT/JP2023/036306
(87) International publication number: WO 2024/084976

(57) **Abstract**

Provided is a ferrite particle powder for electromagnetic wave absorption that can maintain flexibility and uniformity of physical properties of a sheet even when the sheet is highly filled with the ferrite particle powder and that is excellent in electromagnetic wave absorbing performance in a GHz band. The ferrite particle powder for electromagnetic wave absorption includes magnetoplumbite-type ferrite represented by a chemical formula: AₓFe_{(12-y)}(Ti_{z}Mn_{(1-z)})_{y}O₁₉, in which A is at least one selected from Ba, Sr, Ca, and Pb, x is 0.9 to 1.1, y is 5.0 or less, and z is 0.35 to 0.65. The ferrite particle powder has a compression density of 3.00 g/cm³ or more, and has a D10 of 0.8 µm or less and a D90 of 8.6 µm or less determined by a laser diffraction method.

## Description

### TECHNICAL FIELD

The present disclosure relates to a ferrite particle powder for electromagnetic wave absorption, a method for manufacturing the ferrite particle powder for electromagnetic wave absorption, and a resin composition and an electromagnetic wave absorber using the ferrite particle powder for electromagnetic wave absorption.

### BACKGROUND ART

With advancement of information communication, 5G communication that has been spreading in recent years is expected to be used for many electronic devices. For this 5G communication, a radio wave having a frequency in the GHz band capable of transmitting large-capacity information at a high speed with a low delay and simultaneous connection is used.

In addition, densification of electronic components has progressed along with miniaturization of the electronic devices. When a current flows through a densified electronic component, some energy may be radiated as an electromagnetic wave to another electronic component.

Furthermore, the radiated electromagnetic wave may be reflected in a housing of the electronic device. As a result, these radiated or reflected electromagnetic waves may cause malfunction of the electronic device. In order to suppress an electromagnetic wave noise that causes such malfunction, an electromagnetic wave absorber is used.

The electromagnetic wave absorber is often used as a post-countermeasure. From this, the electromagnetic wave absorber to be used is often also attached to a non-flat surface such as an electronic component. Therefore, the electromagnetic wave absorber is required to have good flexibility. At the same time, the electromagnetic wave absorber is often used at a place where there is almost no empty space in an electronic housing in which the electronic components are densely arranged. Therefore, the electromagnetic wave absorber is required to have a thin sheet shape and high electromagnetic wave absorbing performance.

An electromagnetic wave absorbing material is a material that converts absorbed electromagnetic wave energy into thermal energy. That is, an energy loss is the electromagnetic wave absorbing performance. Theoretically, the energy is lost due to magnetic loss, dielectric loss, or conductive loss. Magnetoplumbite-type ferrite (hereinafter, sometimes abbreviated as M-type ferrite) has high crystal magnetic anisotropy. From this, the M-type ferrite exhibits magnetic resonance in the GHz band and indicates an imaginary part µ" of complex magnetic permeability, which results in the magnetic loss at that frequency. Therefore, the M-type ferrite is promising as a high frequency absorbing material.

For example, it is known that M-type barium ferrite has a resonance frequency around 50 GHz. However, due to its large coercive force, it is difficult to say that the M-type barium ferrite is soft magnetic. However, by substituting a part of iron with, for example, titanium, manganese, zinc, cobalt, nickel, copper, tin, or zirconium, soft magnetization proceeds. As a result, the magnetocrystalline anisotropy and saturation magnetization change. Therefore, the resonance frequency can be controlled. In this way, it is possible to obtain electromagnetic wave absorbing ferrite capable of coping with various high frequency bands such as the 5G communication band.

The absorbing performance of the electromagnetic wave absorber obtained from a resin composition containing the M-type ferrite and the resin greatly changes depending on the filling amount of ferrite in the resin composition. In order to improve the electromagnetic wave absorbing performance, it is necessary to increase the filling amount of ferrite. On the other hand, when the filling amount of ferrite is increased, the electromagnetic wave absorber required to have flexibility as the sheet becomes hard and brittle. That is, when the filling amount of ferrite is too large, sheet preparation itself is difficult.

Further, when the ferrite and the resin are kneaded, the resin is melted by heating. At this time, the resin composition having a high filling amount of ferrite has a high viscosity during melting. As a result, it is difficult for components in the resin composition to be uniformly mixed at the time of kneading, and thus fine dispersion is difficult. In particular, when the additive exhibiting the effect in a small amount is not finely dispersed microscopically, the effect of the additive is not sufficiently exhibited.

For example, when the sheet is prepared using a thermosetting resin acrylonitrile-butadiene rubber (NBR), the additive is added in addition to the resin and ferrite. Then, after these components are kneaded, appropriate elasticity and flexibility are imparted to the sheet by vulcanization. At this time, when the resin composition is highly filled with ferrite and thus has a high viscosity during melt-kneading, the additive is not finely dispersed microscopically. As a result, since subsequent vulcanization progresses ununiformly, the physical properties are deteriorated such that the sheet is hard and poor in flexibility.

Patent Literature 1 discloses an electromagnetic wave absorbing sheet having an electromagnetic wave absorbing layer containing magnetic iron oxide, which is an electromagnetic wave absorbing material that performs magnetic resonance in a frequency band of a millimeter wave band or more, and a rubber binder. A maximum elongation percentage of an elastic region in one direction in a plane of the electromagnetic wave absorbing sheet is 20% to 200%. A content rate of the magnetic iron oxide in the electromagnetic wave absorbing layer is 30 vol% or more. As the magnetic iron oxide, epsilon iron oxide or strontium ferrite is used.

Patent Literature 2 discloses a magnetoplumbite-type hexagonal ferrite which is represented by a composition formula of AFe_{(12-X)}(B1_{0.5}(Co_{(1-y)}Zn_{y})_{0.5})ₓO₁₉ and is suitable for the electromagnetic wave absorber for the GHz band. Here, A is one or two of Ba and Sr. B1 is one or two of Ti and Zr. x is 0.1 to 2.0. y is 0.2 to 0.8.

### CITATION LIST

### PATENT LITERATURE

Patent Literature 1: JP-A-2019-75571
Patent Literature 2: JP-A-2010-260766

### SUMMARY OF INVENTION

### PROBLEMS TO BE SOLVED BY INVENTION

The electromagnetic wave absorbing sheet is required to have flexibility and high electromagnetic wave absorbing performance. In order to improve the electromagnetic wave absorbing performance of the electromagnetic wave absorbing sheet using the M-type ferrite having electromagnetic wave absorbing performance in the GHz band, the sheet needs to be highly filled with ferrite powder. However, in general, as the filling amount of the powder is increased, the flexibility of the sheet is significantly reduced. As a result, when the filling amount of the powder is excessively increased, the sheeting itself is difficult.

Further, when the filling amount of the powder is increased, viscosity during melt-kneading of the resin composition increases. Therefore, it is difficult to finely disperse each component in the resin composition. As a result, the flexibility and the uniformity of physical properties of the sheet are significantly reduced. In particular, an effect of an additive is exhibited by a trace amount of the additive. Therefore, there is a problem that processability and physical properties of the sheet are greatly affected when the additive is not finely dispersed microscopically.

Since an elongation percentage of an electromagnetic wave absorbing resin sheet containing magnetic iron oxide such as ferrite in the resin described in Patent Literature 1 is controlled, the electromagnetic wave absorbing resin sheet can also be installed in a portion where a shape of an installation place is not flat. However, this literature does not describe remedying, by powder control of magnetic iron oxide such as ferrite, a problem that when the resin composition highly filled with a filler is kneaded, microscopic fine dispersion of each component is deteriorated due to the high viscosity of the resin composition in a molten state, and thus sheet physical properties are also deteriorated.

The magnetoplumbite-type hexagonal ferrite suitable for the electromagnetic wave absorber for the GHz band described in Patent Literature 2 can suppress frequency fluctuation due to thickness fluctuation of the electromagnetic wave absorbing resin sheet containing ferrite to small fluctuation. However, in this document, when the resin composition containing a large amount of a filler is kneaded, the viscosity of the resin composition in a molten state increases. Therefore, the microscopic fine dispersion of each component deteriorates with kneading. The physical properties of the sheet also deteriorate. The above document does not describe that such a problem is improved by powder control of magnetic iron oxide such as ferrite.

The present disclosure addresses the above problems. That is, an object of the present disclosure is to provide a ferrite particle powder for electromagnetic wave absorption that can maintain flexibility and uniformity of physical properties of a sheet even when the sheet is highly filled with the ferrite particle powder and that is excellent in electromagnetic wave absorbing performance in the GHz band, a resin composition containing the ferrite particle powder for electromagnetic wave absorption, and an electromagnetic wave absorber using the resin composition.

### SOLUTION TO PROBLEMS

As a result of intensive studies to solve the above problems, the researchers have found that the above problems are solved by optimizing powder characteristics to be focused of an M-type ferrite powder to predetermined characteristics.

That is, a first embodiment of the present disclosure is a ferrite particle powder for electromagnetic wave absorption, the ferrite particle powder containing magnetoplumbite-type ferrite represented by a chemical formula: AₓFe_{(12-y)}(Ti_{z}Mn_{(1-z}))_{y}O₁₉, in which A is at least one selected from Ba, Sr, Ca, and Pb, x is 0.9 to 1.1, y is 5.0 or less, and z is 0.35 to 0.65, having a compression density of 3.00 g/cm³ or more, and having a D10 of 0.8 µm or less and a D90 of 8.6 µm or less determined by a laser diffraction method.

A second embodiment of the present disclosure is a method for manufacturing the ferrite particle powder for electromagnetic wave absorption according to the first embodiment, the method including: mixing, molding, and firing an iron raw material, a titanium raw material, a manganese raw material, and a compound raw material of an element A to produce magnetoplumbite-type ferrite; pulverizing the magnetoplumbite-type ferrite; and then annealing the pulverized magnetoplumbite-type ferrite.

A third gist of the present invention is a resin composition containing the ferrite particle powder for electromagnetic wave absorption according to the first embodiment and a resin.

A fourth gist of the present invention is an electromagnetic wave absorber containing the ferrite particle powder for electromagnetic wave absorption according to the first embodiment and a resin.

### EFFECTS OF INVENTION

According to the ferrite particle powder for electromagnetic wave absorption and the resin composition using the same according to the present embodiments, even an electromagnetic wave absorber (electromagnetic wave absorbing sheet) highly filled with ferrite particle powder can maintain flexibility and uniformity of physical properties of the sheet. In addition, the electromagnetic wave absorber according to the present embodiment is excellent in electromagnetic wave absorbing performance in the GHz band.

### BRIEF DESCRIPTION OF DRAWINGS

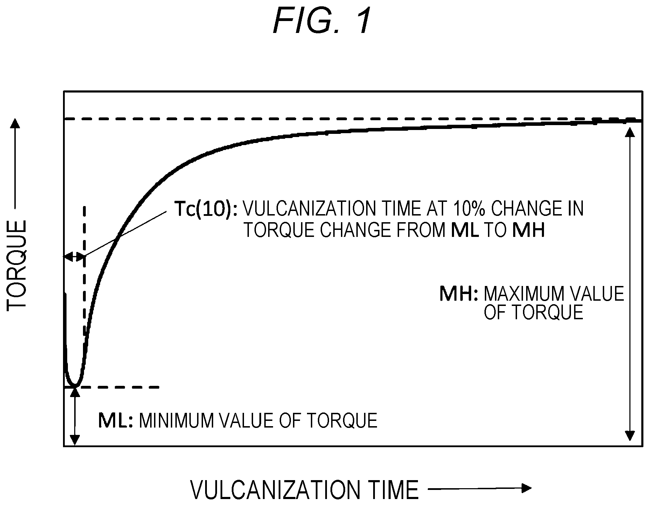

Fig. 1 is a conceptual diagram of a vulcanization curve created using a curelastometer.

### DESCRIPTION OF EMBODIMENTS

Hereinafter, the present embodiment will be described in detail. A ferrite particle powder for electromagnetic wave absorption according to the present embodiment contains magnetoplumbite-type ferrite represented by a chemical formula: AₓFe_{(12-y)}(Ti_{z}Mn_{(1-z)})_{y}O₁₉. Here, A is at least one element selected from Ba, Sr, Ca, and Pb. Preferred elements are Ba and Sr.

x is 0.9 to 1.1, preferably 0.94 to 1.06, and more preferably 0.97 to 1.03. y is 5.0 or less, preferably 0.02 to 4.20, more preferably 0.05 to 3.30, and still more preferably 0.08 to 2.40. z is 0.35 to 0.65, preferably 0.38 to 0.63, and more preferably 0.40 to 0.60. That is, the magnetoplumbite-type ferrite according to the present embodiment contains Ti and Mn in a ratio within a specific range.

When x is less than 0.9 or more than 1.1, it is difficult to obtain single-phase magnetoplumbite-type ferrite. Therefore, x less than 0.9 or more than 1.1 is not preferable. When y exceeds 5.0, saturation magnetization is too low, which raises problems such as an imaginary part µ" of complex magnetic permeability for obtaining the magnetic loss also being low, a part of an additive element being not solid-solved in the ferrite and precipitated as an impurity, or pulverization efficiency decreasing due to a sintered body during reaction firing being significantly hard. Therefore, y exceeding 5.0 is not preferable. When z is less than 0.35 or more than 0.65, electrical neutrality is not maintained, and as a result, the impurity is deposited. Therefore, z less than 0.35 or more than 0.65 is not preferable.

A compression density of the ferrite particle powder for electromagnetic wave absorption according to the present embodiment is 3.00 g/cm³ or more. This makes it possible to reduce viscosity during melt-kneading of the resin composition. When the compression density is less than 3.00 g/cm³, it is difficult to reduce the viscosity during melt-kneading of the resin composition. The compression density is preferably 3.06 g/cm³ or more, and more preferably 3.10 g/cm³ or more. An upper limit of the compression density is, for example, 3.60 g/cm³. The compression density is measured by a method described in Examples described later.

The ferrite particle powder for electromagnetic wave absorption according to the present embodiment has a D10 of 0.8 µm or less and a D90 of 8.6 µm or less, which are obtained by a laser diffraction method. When D10 exceeds 0.8 µm, the viscosity of the resin composition during kneading increases. Therefore, due to insufficient dispersion of components of the resin composition, the flexibility of the electromagnetic wave absorber (electromagnetic wave absorbing sheet) obtained from the resin composition is impaired. When D90 exceeds 8.6 µm, the viscosity of the resin composition during kneading also increases. Therefore, due to insufficient dispersion of components of the resin composition, the flexibility of the electromagnetic wave absorbing sheet is impaired. D10 is preferably 0.75 µm or less, and more preferably 0.65 µm or less. D90 is preferably 8.5 µm or less, more preferably 7.0 µm or less, and still more preferably 6.0 µm or less. The lower limit value of D10 is about 0.4 µm. The lower limit value of D90 is about 2.0 µm.

The ferrite particle powder for electromagnetic wave absorption according to the present embodiment preferably has a specific surface area of 0.50 to 4.0 m²/g. When the specific surface area is less than 0.50 m²/g, the resin space between the ferrite particle powders increases, so that the electromagnetic wave absorbing sheet becomes brittle. As a result, the flexibility of the sheet is impaired. When the specific surface area exceeds 4.0 m²/g, the wettability between the surface of the ferrite particle powder and the resin is deteriorated, and thus the flexibility of the sheet is impaired. The specific surface area is more preferably 1.00 to 3.80 m²/g, still more preferably 1.40 to 3.60 m²/g, and even more preferably 1.80 to 3.50 m²/g.

An average particle diameter (Ps-b) of the ferrite particle powder for electromagnetic wave absorption according to the present embodiment, which is determined by an air permeation method (Blaine method), is preferably 0.50 to 3.0 µm. When the average particle diameter (Ps-b) is less than 0.50 µm, the wettability between the surface of the ferrite particle powder and the resin is deteriorated. Therefore, the flexibility of the sheet may be impaired. When the average particle diameter (Ps-b) exceeds 3.0 µm, the resin space between the ferrite particle powders increases. This may make the electromagnetic wave absorbing sheet brittle. In this case, the flexibility of the sheet is impaired. The average particle diameter (Ps-b) is more preferably 0.65 to 2.50 µm, and still more preferably 0.80 to 2.00 µm.

Next, a method for manufacturing the ferrite particle powder for electromagnetic wave absorption according to the present embodiment will be described.

In the method for manufacturing the ferrite particle powder for electromagnetic wave absorption according to the present embodiment, an iron raw material, a titanium raw material, a manganese raw material, and a compound raw material of an element A are mixed, molded, and fired to produce a magnetoplumbite-type ferrite. An intended ferrite particle powder for electromagnetic wave absorption is obtained by pulverizing the produced magnetoplumbite-type ferrite and then performing annealing treatment.

As the iron raw material, iron oxide such as α-Fe₂O₃ is preferably used. As the titanium raw material, titanium oxide such as TiO₂ is preferably used. As the manganese raw material, manganese oxide such as Mn₂O₃ or Mn₃O₄ is preferably used. Preferable examples of the raw material of the element A include oxides, hydroxides, and carbonates of Ba, Sr, Ca, and Pb.

First, the iron raw material, the titanium raw material, the manganese raw material, and the compound raw material of the element A weighed at a ratio corresponding to x, y, and z of the chemical formula: AₓFe_{(12-y)}(Ti_{z}Mn_{(1-z)})_{y}O₁₉ are mixed. These raw materials are mixed using, for example, a wet attritor, a homomixer, or a high-speed mixer. The obtained raw material mixture is pulverized and then granulated using an extrusion molding machine or the like.

During pulverization or granulation of the raw material mixture, a flux is preferably added. Then, the obtained molded body is fired. Preferred examples of the flux include BaCl_{8.4}H₂O, SrCl₂ 6H₂O, CaCl_{8.4}H₂O, KCl, MgCl₂, NaCl, and Na₂B₄O₇. An addition amount of the flux is preferably 0.1 to 10.0 wt%, and more preferably 0.1 to 8.0 wt% with respect to the raw material mixture obtained as described above.

Further, Bi₂O₃ as a reaction accelerator may be added to and mixed with the raw material mixed powder or the pulverized powder after firing.

The obtained molded body is fired to produce magnetoplumbite-type ferrite. A firing temperature is preferably 1000°C to 1400°C, and more preferably 1050°C to 1350°C. When the firing temperature is lower than 1000°C, a ferritization reaction may not proceed sufficiently. Therefore, a single phase may not be obtained, or a theoretical saturation magnetization value (σs) in a corresponding composition may not be obtained. When the firing temperature is higher than 1400°C, fusion by sintering of particles proceeds, and thus a burden is imposed on a manufacturing process such as pulverization for controlling the particle diameter to a predetermined value. Therefore, the firing temperature higher than 1400°C is not preferable.

The obtained fired product is pulverized. The pulverization may be performed at room temperature. The pulverization is performed using, for example, a hammer mill, a wet attritor, or the like. In the case of pulverization with a wet attritor, water washing, filtration, and drying are thereafter performed.

Next, the obtained pulverized product is annealed in the air, preferably at 600°C to 1100°C, and more preferably at 650°C to 1050°C. The annealing temperature of higher than 1100°C is not preferable because fusion by sintering of the particles proceeds, and it is difficult to obtain a powder having good dispersibility. Note that the annealing treatment is performed at a temperature lower than the firing temperature. In the present invention, the annealing treatment performed in this temperature range is important for achieving the powder characteristics of the magnetoplumbite-type ferrite particle powder defined in the present invention.

Next, the resin composition according to the present embodiment and the electromagnetic wave absorber (electromagnetic wave absorbing sheet) according to the present embodiment will be described.

The resin composition according to the present embodiment includes a ferrite particle powder for electromagnetic wave absorption and a resin. Examples of the resin include a hydrogenated styrene-based thermoplastic elastomer (SEBS), a vinyl chloride resin, an ethylene-vinyl acetate copolymer resin, an ethylene-ethyl acrylate copolymer resin, a PPS resin, a polyamide (nylon) resin, a polyamide elastomer, a polymerized fatty acid-based polyamide, an acrylonitrile butadiene rubber (NBR), a natural rubber (NR), an isoprene rubber (IR), an ethylene propylene rubber (EPDM), an acrylic rubber (ACM), and a silicone rubber (Q). Further, a mixing ratio of the ferrite particle powder for electromagnetic wave absorption is preferably 20 to 75 vol%.

In order to improve compatibility and dispersibility of a ferrite particle for electromagnetic wave absorption in the resin, the ferrite particle powder for electromagnetic wave absorption is preferably surface-treated in advance with a surface treatment agent. Examples of the surface treatment agent that can be added include a silane coupling agent and a titanate coupling agent. Furthermore, examples of the additive that can be added as necessary include a plasticizer, a reinforcing agent, a heat resistance improver, a thermally conductive filler, a pressure-sensitive adhesive, an antioxidant, a light stabilizer, an antistatic agent, and a colorant.

When various coupling agents are used, a coupling agent having, as functional groups, any one of a vinyl group, an epoxy group, an amino group, a methacrylic group, a mercapto group, a phosphoryl group, and a sulfo group and an alkoxy group such as a methoxy group or an ethoxy group can be used.

The ferrite particle powder for electromagnetic wave absorption (which may be surface-treated as necessary), the resin, and various additives as necessary are kneaded to produce a resin composition. The shape of the resin composition is not particularly limited, but the resin composition is suitably used as a molding material of an electromagnetic wave absorber by being pulverized or cut into particles or pellets. Thereafter, the obtained resin composition is molded and rolled into a desired thickness and shape by a known method. In this way, the electromagnetic wave absorber (electromagnetic wave absorbing sheet) is manufactured.

When rubber is used as the resin, the resin may be vulcanized by the following method. First, additives such as a vulcanizing agent (sulfur), a vulcanization accelerator (for example, 2-mercaptobenzothiazole (MBT) or N-cyclohexyl-2-benzothiazole sulfenamide (CBS)), or a vulcanization accelerator aid (for example, stearic acid or zinc oxide) are added to the resin composition. Then, components of the resin composition are kneaded, molded, and rolled at a temperature (for example, 60°C to 100°C) lower than a temperature at which a vulcanization reaction occurs to manufacture an unvulcanized sheet. Thereafter, the unvulcanized sheet is hot-pressed at a temperature (for example, 120°C to 200°C) at which the vulcanization reaction occurs. In this way, a vulcanized electromagnetic wave absorbing sheet is obtained.

The reason why the ferrite particle powder for electromagnetic wave absorption according to the present embodiment is suitable as the material of the electromagnetic wave absorber is not known yet in detail but estimated as follows. In order to improve the electromagnetic wave absorbing performance of the ferrite particle powder itself, it is important that the theoretical saturation magnetization value (σs) in the corresponding composition is obtained, and elements constituting the corresponding composition are finely dispersed microscopically. In the present embodiment, by optimizing the method for manufacturing the ferrite, the ferrite particle powder satisfying the above two points is obtained. This achieves high electromagnetic wave absorbing performance.

In addition, the compression density is controlled to 3.0 g/cm³ or more. Furthermore, D10 is controlled to 0.8 µm or less, and D90 is controlled to 8.6 µm or less. Thus, the viscosity during melt-kneading of the resin composition decreases, so that constituent elements of the resin composition can be finely dispersed microscopically. In addition, the ferrite particle powder has an excellent reinforcing effect on physical properties of the electromagnetic wave absorbing sheet. This makes it possible to obtain the electromagnetic wave absorbing sheet having excellent flexibility.

As the compression density of the ferrite particle powder increases, the viscosity during melt-kneading of the resin composition can be further decreased. Therefore, the additive can be finely dispersed microscopically. As a result, the effect can be exhibited by a trace amount of the additive.

### EXAMPLES

Representative embodiments of the present disclosure are as follows. First, a measurement method and an evaluation method will be described.

Amounts of elements (Ti, Mn, Zn, Ba, and Fe) contained in the ferrite particle powder were measured with an X-ray fluorescence spectrometer "ZSX Primus II" (manufactured by Rigaku Corporation). The obtained amounts of Ti, Mn, Zn, Ba, and Fe were converted into moles to calculate composition ratios x, y, and z.

As the compression density of the ferrite particle powder, the density of the particle powder when compressed at a pressure of 1 t/cm² by a hydraulic press machine was adopted.

The D10 and D90 of the ferrite particle powder were measured using a "laser diffraction particle size distribution analyzer HELOS & RODOS (measurement unit type HELOS/BF-M, airflow type dry dispersion unit RODOS/M)" (manufactured by Sympatec GmbH). Specifically, a sample dispersed at a dispersion pressure of 5 bar in the RODOS/M was measured by the HELOS/BF-M under the condition of a measurement range 1 (0.1/0.18 to 35 µm). The 10% particle diameter in the cumulative particle size distribution was denoted as D10, and the 90% particle diameter was denoted as D90.

The specific surface area of the ferrite particle powder was measured using a "specific surface area analyzer Macsorb" (manufactured by Mountech Co., Ltd.). Specifically, the specific surface area was measured based on the principle of the BET one-point method using a nitrogen gas adsorption/desorption characteristic with respect to a sample.

The average particle diameter (Ps-b) of the ferrite particle powder determined by the air permeability method (Blaine method) was measured by a "constant-pressure ventilation type rapid standard universal powder specific surface area measuring apparatus" (manufactured by Shimadzu Corporation).

As electromagnetic wave absorption characteristics of the electromagnetic wave absorbing sheet prepared using the ferrite particle powder, an absorption peak frequency and a transmission attenuation amount (S₂₁) were measured using a "network analyzer E8361A" (manufactured by Agilent Technologies).

A tensile elastic modulus was measured according to JIS K6251 standard by the following method. First, a lump rubber composition was prepared using a "Labo Plastomill 4C150" (manufactured by Toyo Seiki Seisaku-sho, Ltd.). Thereafter, an unvulcanized rubber sheet was prepared using a "tabletop test mixing roll 191-TM" (manufactured by YASUDA SEIKI SEISAKUSHO, LTD.). Subsequently, a vulcanized rubber sheet was prepared using a "hot press machine" (manufactured by TESTER SANGYO CO., LTD.). Further, a dumbbell test piece (total length 115 mm, width 25.0 mm, thickness 2.0 mm ± 0.2 mm) was obtained using a test piece punching blade No. 5. Thereafter, the tensile elastic modulus was measured using a "computer-measured and controlled precision universal tester AG-1" (manufactured by Shimadzu Corporation).

A vulcanization curve was obtained using a curelastometer in accordance with JIS K6300-2 standard (Die vulcanization test method A). From this vulcanization curve, the maximum value MH of torque and the 10% vulcanization time Tc(10) were obtained. A lump rubber composition was prepared using a "Labo Plastomill 4C150" (manufactured by Toyo Seiki Seisaku-sho, Ltd.). Thereafter, an unvulcanized rubber sheet (thickness 3.2 ± 0.2 mm) was prepared using a "tabletop test mixing roll 191-TM" (manufactured by YASUDA SEIKI SEISAKUSHO, LTD.). A circular resin sheet having a diameter of 45 mm was punched out from the sheet. Thereafter, the vulcanization curve was obtained using a "Curelastometer 7" (manufactured by JSR trading Co., Ltd.). In this measurement method, the resin sheet punched into a circular shape is vulcanized by applying a torsional torque while being heated. A vulcanization property is obtained from a curve representing a torque change from before the start of vulcanization to the end of vulcanization.

Fig. 1 is a conceptual diagram of a vulcanization curve created using a curelastometer. From the vulcanization curve, information on sheet physical properties of the resin including a minimum value ML of torque before vulcanization and a maximum value MH of torque after vulcanization is obtained. Furthermore, information on a speed of vulcanization, such as a 10% vulcanization time Tc(10) (time from the start of vulcanization to completion of 10% change in torque change from ML to MH), is also obtained.

The maximum value MH of torque after vulcanization is an index indicating how much elasticity the sheet after vulcanization has. A higher value indicates that the sheet is harder. A lower value indicates that the sheet is softer.

Further, the 10% vulcanization time Tc(10) is a time required for initial vulcanization. The smaller this value, the faster the vulcanization proceeds. Considering a sheet state when vulcanization proceeds quickly, it is difficult to say that fine dispersion of components such as additives has been sufficiently achieved when the time required for initial vulcanization is short (Tc(10) is small). As a result, it is expected that uneven vulcanization has occurred. In addition, when the initial vulcanization gradually progresses (Tc(10) is large), it is considered that uniform vulcanization has occurred.

### Examples 1 to 7:

### <Manufacturing of ferrite particle powder>

Various powder raw materials (α-Fe₂O₃, TiO₂, Mn₃O₄, BaCO₃) weighed so that compositions of final treated products had composition formulas shown in Table 1 were mixed for 15 minutes by a wet attritor. The resulting mixture was then filtered and dried. BaCl_{8.4}H₂O was added to the obtained raw material mixed powder, and the resulting mixture was well mixed. The resulting mixture was then extruded. At this time, an addition amount of BaCl_{8.4}H₂O was 3.0 wt% with respect to the raw material mixed powder. The obtained granulated product was fired at 1280°C in the air. The obtained fired product was coarsely pulverized, and subsequently pulverized by the wet attritor. The obtained pulverized product was washed with water, filtered, and dried. Subsequently, the obtained pulverized product was annealed at 600°C in the air. Manufacturing conditions at this time are shown in Table 1, and various properties of the obtained ferrite particle powders are shown in Table 2.

### Comparative Example 1:

A ferrite particle powder was manufactured by the same method as in Example 1 except that composition of the ferrite particle powder was changed (Zn was added), and the annealing treatment was not performed. Manufacturing conditions at this time are shown in Table 1, and various properties of the obtained ferrite particle powders are shown in Table 2.

**[Table 1]**

| | **Composition** | | **Manufacturing conditions of ferrite particle powder** | | | | **Powder characteristics of ferrite particle powder** | | | | |
|---|---|---|---|---|---|---|---|---|---|---|---|
| | **Substitution amount y** | **Composition formula** | **BaCl₂** | **Na₂B₄O₇** | **Firing temperature** | **Annealing temperature** | **Ps-b** | **D10** | **D90** | **CD** | **Specific surface area (m²/g)** |
| | | | **(wt%)** | **(wt%)** | **(°C)** | **(°C)** | **(um)** | **(um)** | **(um)** | **(g/cm³)** | |
| **Example 1** | **1.5** | **Ba_{1.0}Fe_{10.5}(Ti_{0.5}Mn_{0.5})_{1.0}O₁₉** | **3** | **0** | **1280** | **600** | **1.13** | **0.55** | **3.89** | **3.24** | **2.91** |
| **Example 2** | **1.5** | **Ba_{1.0}Fe_{10.5}(Ti_{0.5}Mn_{0.5})_{1.5}O₁₉** | **3** | **0.6** | **1280** | **700** | **1.88** | **0.76** | **8.6** | **3.37** | **1.60** |
| **Example 3** | **1.6** | **Ba_{1.0}Fe_{10.4}(Ti_{0.5}Mn_{0.5})_{1.6}O₁₉** | **3** | **0** | **1150** | **600** | **0.81** | **0.48** | **2.84** | **3.02** | **3.44** |
| **Example 4** | **2.4** | **Ba_{1.0}Fe_{9.6}(Ti_{0.5}Mn_{0.5})_{2.4}O₁₉** | **2** | **0** | **1280** | **600** | **1.36** | **0.62** | **8.50** | **3.24** | **2.38** |
| **Example 5** | **1.8** | **Ba_{1.0}Fe_{10.2}(Ti_{0.5}Mn_{0.5})_{1.8}O₁₉** | **4** | **0** | **1290** | **600** | **1.27** | **0.66** | **4.02** | **3.10** | **2.18** |
| **Example 6** | **1.1** | **Ba_{1.0}Fe_{10.9}(Ti_{0.5}Mn_{0.5})_{1.1}O₁₉** | **4** | **0** | **1280** | **900** | **1.30** | **0.71** | **4.04** | **3.23** | **1.82** |
| **Example 7** | **0.1** | **Ba_{1.0}Fe_{11.9}(Ti_{0.4}Mn_{0.6})_{0.1}O₁₉** | **4** | **0.3** | **1280** | **600** | **1.35** | **0.67** | **5.86** | **3.25** | **2.18** |
| **Comparative Example 1** | **1.5** | **Ba_{1.0}Fe_{10.5}(Ti_{0.5}(Mn_{0.5}Zn_{0.5})_{0.5})_{1.5}O₁₉** | **3** | **0** | **1280** | **-** | **1.46** | **0.86** | **8.78** | **2.86** | **1.83** |

**[Table 2]**

| | **Powder characteristics of ferrite particle powder** | | | |
|---|---|---|---|---|
| | **Substitution amount y** | **Ps-b** | **CD** | **Specific surface area** |
| | | **(um)** | **(g/cm³)** | **(m²/g)** |
| **Example 1** | **1.5** | **1.13** | **3.24** | **2.91** |
| **Example 2** | **1.5** | **1.88** | **3.37** | **1.60** |
| **Example 3** | **1.6** | **0.81** | **3.02** | **3.44** |
| **Example 4** | **2.4** | **1.36** | **3.24** | **2.38** |
| **Example 5** | **1.8** | **1.27** | **3.10** | **2.18** |
| **Example 6** | **1.1** | **1.30** | **3.23** | **1.82** |
| **Example 7** | **0.1** | **1.35** | **3.25** | **2.18** |
| **Comparative Example 1** | **1.5** | **1.46** | **2.86** | **1.83** |

### Examples 8 to 13:

### <Preparation of electromagnetic wave absorbing sheet>

60.0 vol% of each ferrite particle powder obtained in Examples 1 to 6, 39.0 vol% of a hydrogenated styrene-based thermoplastic elastomer (SEBS) resin, and 1.0 vol% of a titanate coupling agent (PLENACT TTS manufactured by Ajinomoto Fine-Techno Co., Inc.) were roll-kneaded at 160°C. Thereafter, the obtained kneaded product (resin composition) was molded and rolled to prepare an electromagnetic wave absorbing sheet. In the course of molding and rolling, a thickness of the electromagnetic wave absorbing sheet to be prepared was adjusted to 1 mm.

The absorption peak frequency and the transmission attenuation amount (S₂₁) of the obtained electromagnetic wave absorbing sheet were measured using a "network analyzer E8361A" (manufactured by Agilent Technologies). The electromagnetic wave absorption characteristics at this time are shown in Table 3.

**[Table 3]**

| | **Used ferrite particle powder** | **Radio wave absorption characteristics** | |
|---|---|---|---|
| | | **Peak frequency (GHz)** | **Transmission attenuation amount (dB)** |
| **Example 8** | **Example 1** | **30.6** | **-9.1** |
| **Example 9** | **Example 2** | **31.0** | **-9.5** |
| **Example 10** | **Example 3** | **29.9** | **-8.3** |
| **Example 11** | **Example 4** | **24.3** | **-7.8** |
| **Example 12** | **Example 5** | **28.3** | **-7.9** |
| **Example 13** | **Example 6** | **34.9** | **-9.5** |
| **Comparative Example 3** | **Comparative Example 1** | **29.1** | **-8.3** |

### Comparative Example 2:

60.0 vol% of each ferrite particle powder obtained in Comparative Example 1, 39.0 vol% of a hydrogenated styrene-based thermoplastic elastomer (SEBS) resin, and 1.0 vol% of a titanate coupling agent (PLENACT TTS manufactured by Ajinomoto Fine-Techno Co., Inc.) were roll-kneaded at 160°C. However, a lump resin kneaded product was obtained during kneading. Then, a phenomenon occurred in which the kneaded product was not caught in a molding roll. Therefore, preparation of the electromagnetic wave absorbing sheet using the SEBS resin was abandoned.

### Comparative Example 3:

Therefore, a sheet was prepared using NBR as an alternative resin for the SEBS resin that had been used in Comparative Example 2 in which sheet preparation had been abandoned. 60.0 vol% of each ferrite particle powder obtained in Comparative Example 1, 35.0 vol% of NBR (N239SV manufactured by JSR Corporation), and 0.69 vol% of stearic acid, 0.26 vol% of zinc oxide, 0.25 vol% of sulfur, 0.55 vol% of N-cyclohexyl-2-benzothiazole sulfenamide (CBS), and 3.3 vol% of Polysizer W320 (manufactured by DIC Corporation) as additives such as the vulcanizing agent and the vulcanization accelerator were kneaded at 80°C. Thereafter, the obtained kneaded product (resin composition) was molded and rolled at 60°C to prepare an unvulcanized sheet. In the course of molding and rolling, the thickness of the unvulcanized sheet to be prepared was adjusted to 1.0 mm. Subsequently, the unvulcanized sheet was heated at 150°C using a hot press. Thereafter, a pressure of 3 MPa was applied for 10 minutes to prepare a vulcanized electromagnetic wave absorbing sheet. Electromagnetic wave absorption measurement of the obtained electromagnetic wave absorbing sheet was performed in the same manner as in Examples 8 to 13.

### Examples 14 to 16 and Comparative Example 4:

### <Preparation of dumbbell test piece for tensile test>

60.0 vol% of each ferrite particle powder obtained in Examples 1, 3, and 5 and Comparative Example 1, 35.0 vol% of NBR (N239SV manufactured by JSR Corporation), and 0.69 vol% of stearic acid, 0.26 vol% of zinc oxide, 0.25 vol% of sulfur, 0.55 vol% of N-cyclohexyl-2-benzothiazole sulfenamide (CBS), and 3.3 vol% of Polysizer W320 (manufactured by DIC Corporation) as additives such as the vulcanizing agent and the vulcanization accelerator were kneaded at 80°C. Thereafter, the obtained kneaded product (resin composition) was molded and rolled at 60°C to prepare an unvulcanized sheet. In the course of molding and rolling, the thickness of the unvulcanized sheet was adjusted to 2.0 mm. Subsequently, the unvulcanized sheet was heated at 180°C for 25 minutes by hot pressing. Thereafter, a pressure of 3 MPa was applied for 5 minutes to prepare a vulcanized electromagnetic wave absorbing sheet. Thereafter, a dumbbell test piece was punched out from the sheet using a test piece punching blade No. 5. The tensile elastic modulus of the test piece molded body is shown in Table 4.

### <Preparation of test piece for vulcanization curve measurement>

60.0 vol% of ferrite particle powder obtained in Examples 1, 3, and 5 and Comparative Example 1, 35.0 vol% of NBR (N239SV manufactured by JSR Corporation), and 0.69 vol% of stearic acid, 0.26 vol% of zinc oxide, 0.25 vol% of sulfur, 0.55 vol% of N-cyclohexyl-2-benzothiazole sulfenamide (CBS), and 3.3 vol% of Polysizer W320 (manufactured by DIC Corporation) as additives such as the vulcanizing agent and the vulcanization accelerator were kneaded at 80°C. Thereafter, the obtained kneaded product (resin composition) was molded and rolled to a thickness of 3.2 mm with a roll at 60°C to prepare an unvulcanized sheet. In the course of molding and rolling, the thickness of the unvulcanized sheet to be obtained was adjusted to 3.2 mm. Subsequently, a circular test piece was punched out from the sheet using a circular punching blade (diameter: 45 mm).

The maximum value MH of torque and the 10% vulcanization time Tc(10) obtained from the vulcanization curve at 180°C of the test piece molded body are shown in Table 4.

**[Table 4]**

| **Comparative Example 4** | **Used ferrite particle powder** | **Sheet evaluation** | | |
|---|---|---|---|---|
| | | **Tensile elastic modulus** | **MH** | **Tc(10)** |
| | | **(MPa)** | **(kgf·cm)** | **(min.)** |
| **Example 14** | **Example 1** | **21.5** | **15.6** | **1.0** |
| **Example 15** | **Example 3** | **29.0** | **18.6** | **1.1** |
| **Example 16** | **Example 5** | **33.4** | **15.4** | **1.1** |
| **Comparative Example 4** | **Comparative Example 1** | **40.4** | **22.5** | **0.7** |

As is apparent from Table 4, the tensile elastic moduli of Examples 14, 15, and 16 had low values of 21 to 34 MPa. On the other hand, Comparative Example 4 exhibited a high value of 40 MPa or more. From this, it is apparent that when the ferrite of Examples is used, a sheet which is easy to stretch and soft can be prepared.

Next, the MHs of Examples 14, 15, and 16 had low values of 15 to 19 kgf·m. On the other hand, Comparative Example 4 exhibited a high value of 20 kgf·cm or more. From this, it is apparent that when the ferrite of Examples is used, a soft sheet can be prepared.

Further, the Tc(10)s of Examples 14, 15, and 16 were confirmed to be 1.0 minute or more. In contrast, Tc(10) of Comparative Example 4 was confirmed to be a short time of 0.7 minute or less. From this, uniform vulcanization is achieved in the ferrite of Examples. That is, it is considered that components contained in the resin composition are finely dispersed because the viscosity during melt-kneading of the resin composition is low.

### INDUSTRIAL APPLICABILITY

The ferrite particle powder for electromagnetic wave absorption according to the present embodiment can maintain flexibility and uniformity of physical properties of a sheet even when the sheet is highly filled with the ferrite particle powder and is excellent in electromagnetic wave absorbing performance in a GHz band. Therefore, the ferrite particle powder for electromagnetic wave absorption according to the present embodiment can be suitably used for the electromagnetic wave absorbing material.

## Claims

1. A ferrite particle powder for electromagnetic wave absorption comprising magnetoplumbite-type ferrite represented by a chemical formula: AₓFe_{(12-y)}(Ti_{z}Mn_{(1-z)})_{y}O₁₉, wherein A is at least one selected from Ba, Sr, Ca, and Pb, x is 0.9 to 1.1, y is 5.0 or less, and z is 0.35 to 0.65,
the ferrite particle powder having a compression density of 3.00 g/cm³ or more, and having a D10 of 0.8 µm or less and a D90 of 8.6 µm or less determined by a laser diffraction method.

2. The ferrite particle powder for electromagnetic wave absorption according to claim 1, the ferrite particle powder having a specific surface area of 0.50 to 4.0 m²/g.

3. A method for manufacturing the ferrite particle powder for electromagnetic wave absorption according to claim 1, the method comprising:
mixing, molding, and firing an iron raw material, a titanium raw material, a manganese raw material, and a compound raw material of an element A to produce magnetoplumbite-type ferrite;
pulverizing the magnetoplumbite-type ferrite; and
annealing the pulverized magnetoplumbite-type ferrite.

4. A resin composition comprising the ferrite particle powder for electromagnetic wave absorption according to claim 1 and a resin.

5. An electromagnetic wave absorber comprising the ferrite particle powder for electromagnetic wave absorption according to claim 1 and a resin.
